# EUROPEAN PATENT APPLICATION

(11) **EP 4 081 008 A1**
(43) Date of publication of application: **26.10.2022**
(21) Application number: 20914393.2
(22) Date of filing: 15.12.2020
(51) Int. Cl.: H05K 7/20

(54) **HEAT DISSIPATION STRUCTURE AND MANUFACTURING METHOD THEREFOR, CHIP STRUCTURE AND ELECTRONIC DEVICE**

(30) Priority: 13.01.2020 CN 202010032310
(71) Applicant: Huawei Technologies Co., Ltd., Shenzhen, Guangdong 518129, (CN)
(72) Inventor: DENG, Chaojun, Shenzhen, Guangdong 518129 (CN)
(74) Representative: Körber, Martin Hans
(86) International application number: PCT/CN2020/136462
(87) International publication number: WO 2021/143427

(57) **Abstract**

This application discloses a heat dissipation structure, a production method thereof, a chip structure, and an electronic device, and pertains to the field of electronic device technologies. The heat dissipation structure includes a peripheral substrate (1), a chip substrate (2), a thermally conductive material (3), and a heat sink (4). One end of the peripheral substrate (1) is connected to the chip substrate (2) along a periphery of the chip substrate (2), and the heat sink (4) is connected to the other end of the peripheral substrate (1). In addition, there is accommodation space among the peripheral substrate (1), the heat sink (4), and the chip substrate (2), the thermally conductive material (3) is filled in the accommodation space, and the chip substrate (2) is configured to place a silicon die (6). Because heat generated by a chip may be dissipated only by using two heat transfer phases: the silicon die (6) and the thermally conductive material (3), a quantity of heat transfer phases is small, so that thermal resistance between the heat transfer phases is reduced. Even if power consumption of the chip increases, the heat generated by the chip may be dissipated by using the silicon die (6) and the thermally conductive material (3), so that heat dissipation efficiency is improved, and a heat dissipation effect is improved.

## Description

This application claims priority to Chinese Patent Application No. 202010032310.7, filed on January 13, 2020 and entitled "HEAT DISSIPATION STRUCTURE, PRODUCTION METHOD THEREOF, CHIP STRUCTURE, AND ELECTRONIC DEVICE", which is incorporated herein by reference in its entirety.

### TECHNICAL FIELD

This application relates to the field of electronic device technologies, in particular, to a heat dissipation structure, a production method thereof, a chip structure, and an electronic device.

### BACKGROUND

As chips are increasingly widely used, a quantity of transistors accommodated in the chip is increasing, a transistor running speed is increasing, and power consumption of the chip is also increasing. If the power consumption of the chip continuously increases, the chip generates a large amount of heat in a running process. When a temperature of the chip is excessively high due to the heat, running of the chip is affected, and many problems are caused to running of a device. Therefore, it is necessary to provide a heat dissipation structure for the chip.

### SUMMARY

Embodiments of this application provide a heat dissipation structure, a production method thereof, a chip structure, and an electronic device, to resolve a heat dissipation problem of a chip. Technical solutions are as follows:

According to an aspect, a heat dissipation structure is provided, where the heat dissipation structure includes a peripheral substrate, a chip substrate, a thermally conductive material, and a heat sink. One end of the peripheral substrate is connected to the chip substrate along a periphery of the chip substrate, and the heat sink is connected to the other end of the peripheral substrate. In addition, there is accommodation space among the peripheral substrate, the heat sink, and the chip substrate, the thermally conductive material is filled in the accommodation space, and the chip substrate is configured to place a silicon die.

According to the heat dissipation structure provided in this embodiment of this application, because heat generated by a chip may be dissipated only by using two heat transfer phases: the silicon die and the thermally conductive material, a quantity of heat transfer phases is small, so that thermal resistance between the heat transfer phases is reduced. Even if power consumption of the chip increases, the heat generated by the chip may be dissipated by using the silicon die and the thermally conductive material, so that heat dissipation efficiency is improved, and a heat dissipation effect is improved.

In an example embodiment, the heat sink includes a heat sink plate and at least one heat sink fin; each heat sink fin is connected to one side of the heat sink plate; and the other side of the heat sink plate is connected to the other end of the peripheral substrate, and there is the accommodation space among the heat sink plate, the peripheral substrate, and the chip substrate.

In an example embodiment, the heat sink further includes a connection part, an upper surface of the connection part is connected to each heat sink fin, and a lower surface of the connection part is connected to the heat sink plate; and there is a reference angle between the connection part and the heat sink plate. One end of the connection part is connected to the heat sink fin, and the other end thereof is connected to the heat sink plate, so that a quantity of heat sink fins can be increased as required.

In an example embodiment, the other side of the heat sink plate is connected to the other end of the peripheral substrate through sealing. The heat sink plate is connected to the peripheral substrate through sealing, so that the thermally conductive material is prevented from being leaked or being in contact with air to cause a reaction.

In an example embodiment, the one end of the peripheral substrate is connected to the chip substrate along the periphery of the chip substrate through sealing. The peripheral substrate is connected to the chip substrate through sealing, so that the thermally conductive material is prevented from being leaked or being in contact with air to cause a reaction.

In an example embodiment, the thermally conductive material is liquid metal. The liquid metal is selected, so that a quantity of heat transfer phases is reduced, and heat dissipation efficiency of the chip can be improved. In addition, wear between the thermally conductive material 3 and the silicon die can be further reduced, and production costs of the chip can be reduced.

In an example embodiment, the liquid metal is gallium or a gallium alloy, where the gallium alloy may be any alloy that includes gallium.

In an example embodiment, the gallium alloy is selected from at least one of a gallium-aluminum alloy, a gallium-bismuth alloy, a gallium-tin alloy, a gallium-indium alloy, a gallium-copper alloy, a gallium-gold alloy, and a gallium-silver alloy. The gallium and the gallium alloy are in a liquid state when the chip works, and the gallium and the gallium alloy have a very low melting point and a very high boiling point. Therefore, both the gallium and the gallium alloy can be adhered to the silicon die very well, and an adhesion degree is high, so that thermal resistance at an interface between the silicon die and the gallium or the gallium alloy can be reduced.

In an example embodiment, a surface that is of silicon die and that is in contact with the thermally conductive material is a smooth surface.

A chip structure is further provided, where the chip structure includes a chip body and a heat dissipation structure disposed on the chip body, and the heat dissipation structure is any heat dissipation structure according to the first aspect.

An electronic device is further provided, where the electronic device includes a circuit board, the circuit board has the foregoing chip structure, and the chip structure includes any one of the foregoing heat dissipation structures.

A production method of a heat dissipation structure is further provided, where the heat dissipation structure includes a peripheral substrate, a chip substrate, a thermally conductive material, and a heat sink, and the method includes: connecting one end of the peripheral substrate to the chip substrate along a periphery of the chip substrate, where a silicon die is placed on the chip substrate; filling the thermally conductive material in accommodation space formed between the chip substrate and the peripheral substrate; and connecting the heat sink to the other end of the peripheral substrate to close the accommodation space.

In an example embodiment, the heat sink includes a heat sink plate and at least one heat sink fin; and the connecting the heat sink to the other end of the peripheral substrate includes: connecting each heat sink fin to one side of the heat sink plate, and connecting the other side of the heat sink plate to the other end of the peripheral substrate.

In an example embodiment, the heat sink further includes a connection part; and the method further includes: connecting an upper surface of the connection part to each heat sink fin, and connecting a lower surface of the connection part to the heat sink plate, where there is a reference angle between the connection part and the heat sink plate.

### BRIEF DESCRIPTION OF DRAWINGS

FIG. 1 is a schematic diagram of a heat dissipation structure in a related technology;
FIG. 2 is a schematic diagram of a heat dissipation structure according to an embodiment of this application;
FIG. 3 is a schematic diagram of a structure of a heat sink according to an embodiment of this application;
FIG. 4 is a schematic diagram of a structure of a heat sink according to an embodiment of this application;
FIG. 5 is a schematic diagram of a structure of a circuit board according to an embodiment of this application; and
FIG. 6 is a schematic diagram of a structure of an electronic device according to an embodiment of this application.

### DESCRIPTION OF EMBODIMENTS

Unless otherwise defined, all technical terms used in embodiments of this application have a same meaning as that usually understood by a person skilled in the art. To make objectives, technical solutions, and advantages of this application clearer, the following further describes implementations of this application in detail with reference to accompanying drawings.

As a quantity of transistors accommodated in a chip increases and an operating speed of the transistors becomes higher, power consumption of the chip is higher. Power consumption of some chips exceeds 200 W, and in the future, a chip whose power consumption exceeds 400 W or even exceeds 500 W may appear. However, because a large amount of heat is generated while power consumption of the chip continuously increases, the large amount of heat generated by the chip needs to be dissipated. However, it is difficult to solve a heat dissipation problem of a high-power chip. Especially for a chip whose power consumption exceeds 250 W, the higher the heating power is, the more difficult it is to solve the heat dissipation problem. If the heat dissipation problem cannot be solved, the chip cannot work, and all investments in chips and chip-related systems cannot be converted into application products.

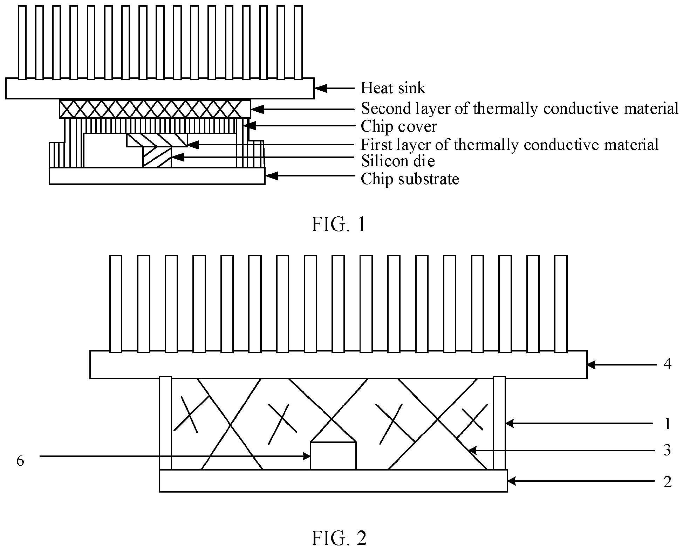

According to a heat dissipation structure provided in a related technology, as shown in FIG. 1, a silicon die is placed on a chip substrate, a first layer of thermally conductive material is disposed between the silicon die and a chip cover, and a second layer of thermally conductive material is disposed between the chip cover and a heat sink. When the heat is dissipated, the heat needs to be first transferred through the silicon die to the first layer of thermally conductive material filled between the silicon die and the chip cover, and then successively passes through the chip cover, the second layer of thermally conductive material filled between the chip cover and the heat sink, and finally reaches the heat sink. Although the heat dissipation structure provided in the related technology can achieve an objective of heat dissipation, heat dissipation needs to be completed through a plurality of heat transfer phases. When power consumption of a chip increases, thermal resistance between the heat transfer phases increases, which affects heat dissipation, causes a serious temperature rise of the chip, and affects normal operation of the device.

Therefore, an embodiment of this application provides a heat dissipation structure. As shown in FIG. 2, the heat dissipation structure includes a peripheral substrate 1, a chip substrate 2, a thermally conductive material 3, and a heat sink 4.

One end of the peripheral substrate 1 is connected to the chip substrate 2 along a periphery of the chip substrate 2, and the heat sink 4 is connected to the other end of the peripheral substrate 1.

There is an accommodation space among the peripheral substrate 1, the heat sink 4, and the chip substrate 2, the thermally conductive material 3 is filled in the accommodation space, and the chip substrate 2 is configured to place a silicon die 6.

According to the heat dissipation structure provided in this embodiment of this application, because heat generated by a chip may be dissipated only by using two heat transfer phases: the silicon die 6 and the thermally conductive material 3, a quantity of heat transfer phases is small, so that thermal resistance between the heat transfer phases is reduced. Even if power consumption of the chip increases, the heat generated by the chip may be dissipated by using the silicon die 6 and the thermally conductive material 3, so that heat dissipation efficiency is improved. In addition, the heat dissipation structure provided in this embodiment of this application can implement good heat dissipation for a chip whose power consumption is greater than 600 W.

For example, the heat dissipation structure may further include a solder ball, and the chip substrate 2 is connected to a circuit board 5 by using the solder ball, to fasten the chip on the circuit board 5.

It can be easily learned that the heat dissipation structure provided in the related technology includes a chip cover. The chip cover can support the heat sink 4 and protect the silicon die 6 placed on the chip substrate 2. However, when the chip cover is added, a heat transfer phase is added, and thermal resistance of the heat transfer phase is increased, thereby affecting heat dissipation. However, in this embodiment of this application, the peripheral substrate 1 is disposed to support a weight of the heat sink 4, so that the heat sink 4 is prevented from damaging the silicon die 6 on the chip substrate 2, and the silicon die 6 can be protected from being damaged.

In addition, the peripheral substrate 1, the chip substrate 2, and the heat sink 4 form a closed accommodation space, and the silicon die 6 is placed on the chip substrate 2. First, the silicon die 6 can be prevented from being exposed to air, so that the silicon die 6 is protected. In addition, the thermally conductive material 3 filled in the accommodation space is prevented from leaking out or reacting with external air or other substances to affect normal operation of the chip.

In an example embodiment, a shape of the peripheral substrate 1 may be determined based on a shape of the chip substrate 2 or a shape of the circuit board 5. For example, when the shape of the chip substrate 2 is a rectangle, the shape of the peripheral substrate 1 may be a rectangle; and when the shape of the chip substrate 2 is a circle, the shape of the peripheral substrate 1 may be a circle. The shape of the peripheral substrate 1 is not limited thereto in this embodiment of this application.

For example, a width of the peripheral substrate 1 may be determined based on an operation requirement for forming the chip. This is not limited in this embodiment of this application.

It should be noted that a size of the accommodation space formed among the peripheral substrate 1, the heat sink 4, and the chip substrate 2 may be determined based on a size of the chip substrate 2. For example, when a large accommodation space is required, a large size of the chip substrate 2 may be disposed. For example, the size of the accommodating space may alternatively be determined based on power consumption of the chip. When the power consumption of the chip is high, more heat is generated. In this case, the accommodating space may be large, to accommodate more thermally conductive material 3, and improve a heat dissipation speed. When the power consumption of the chip is low, the chip generates less heat. In this case, a small accommodation space can also achieve an objective of heat dissipation. In this way, costs of the heat dissipation structure can also be reduced.

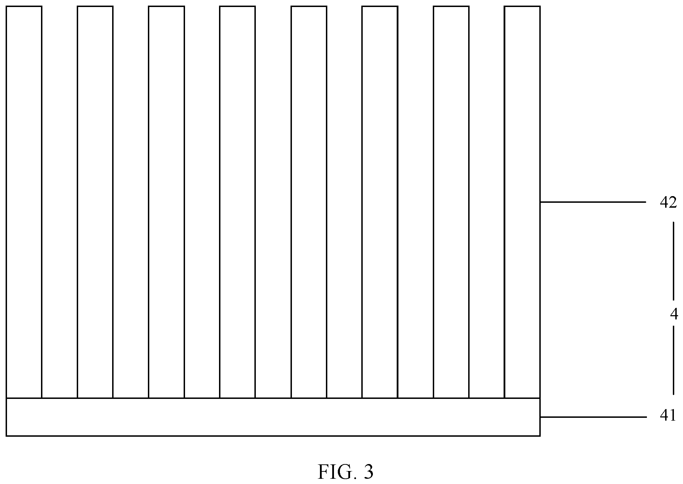

In an example embodiment, as shown in FIG. 3, the heat sink 4 includes a heat sink plate 41 and at least one heat sink fin 42. Each heat sink fin 42 is fixedly connected to one side of the heat sink plate 41, and the other side of the heat sink plate 41 is connected to the other end of the peripheral substrate 1. There is the accommodation space among the heat sink plate 41, the peripheral substrate 1, and the chip substrate 2.

It should be noted that, according to the heat dissipation structure provided in this embodiment of this application, when a chip is manufactured, the heat sink plate 41 may be connected to the other end of the peripheral substrate 1, to form a closed accommodation space, and to ensure that the silicon die 6 placed on the chip substrate 2 is not exposed to air.

For example, each heat sink fin 42 may be integrated with the heat sink plate 41, or the heat sink fin 42 may be welded to the heat sink plate 41. A connection manner of the heat sink fin 42 and the heat sink plate 41 is not limited in this embodiment of this application.

It may be understood that, the heat dissipation structure provided in the related technology further includes a chip cover, a second layer of thermally conductive material is filled between the chip cover and the heat sink 4, and thermal resistance exists in each layer of the filled thermally conductive material, so that a temperature difference exists between the silicon die 6 and the heat sink 4, and the temperature difference reduces heat dissipation efficiency of the heat dissipation structure. However, in the heat dissipation structure provided in this embodiment of this application, the chip cover is replaced with the heat sink plate 41, that is, the chip cover does not need to be disposed. Compared with the related technology, in the heat dissipation structure provided in this embodiment of this application, a heat transfer phase is removed between the silicon die 6 and the heat sink 4, so that thermal resistance between the heat transfer phases is reduced, and heat dissipation efficiency is improved.

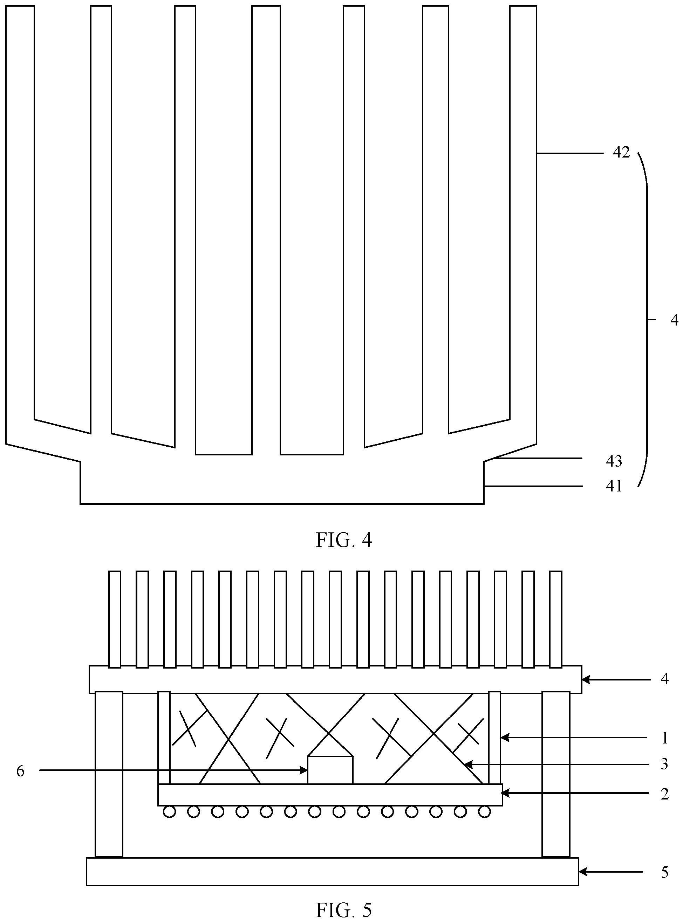

In an example embodiment, as shown in FIG. 4, the heat sink 4 further includes a connection part 43.

An upper surface of the connection part 43 is connected to each heat sink fin 42, and a lower surface of the connection part 43 is connected to the heat sink plate 41. There is a reference angle between the connection part 43 and the heat sink plate 41.

It should be noted that, when the power consumption of the chip is high, the size of the heat sink plate 41 is fixed. In this case, a large quantity of heat sink fins 42 are required to complete heat dissipation of the chip. Therefore, the connection part 43 is disposed, and a size of the connection part 43 is set to be large based on a requirement, so that the connection part 43 can be connected to more heat sink fins 42 to meet a heat dissipation requirement of the chip.

In an example, the reference angle may be within a range of 90° to 180°. In addition, each heat sink fin 42 is fixedly disposed on the upper surface of the connection part 43, and the heat sink plate 41 is fixedly disposed on the lower surface of the connection part 43. For example, each heat sink fin 42 and the upper surface of the connection part 43 may be integrally formed through stamping, or may be connected through welding. The connection part 43 and the heat sink plate 41 may be integrally formed through stamping, or may be connected through welding. This is not limited in this embodiment of this application.

In an example embodiment, the other side of the heat sink plate 41 is connected to the other end of the peripheral substrate 1 through sealing.

The other side of the heat sink plate 41 is disposed to be connected to the other end of the peripheral substrate 1 in a sealed manner, to ensure air-tightness of an accommodation space formed among the peripheral substrate 1, the heat sink plate 41, and the chip substrate 2, and avoid leakage of the thermally conductive material 3 when the chip works.

In an example embodiment, the other side of the heat sink plate 41 is fused and bonded to the other end of the peripheral substrate 1.

In an example embodiment, the one end of the peripheral substrate 1 is connected to the chip substrate 2 along the periphery of the chip substrate 2 through sealing.

Similarly, because the accommodation space needs to accommodate the thermally conductive material 3, the peripheral substrate 1 not only needs to ensure that the thermally conductive material 3 is not exposed to air, but also needs to prevent the heat sink 4 from squeezing the silicon die 6, and also needs to ensure that when the chip works and the temperature rises, the thermally conductive material 3 does not leak from a gap between the peripheral substrate 1 and the chip substrate 2. Therefore, one end of the peripheral substrate 1 is disposed to be connected to the chip substrate 2 in a sealed manner.

In an example embodiment, the one end of the peripheral substrate 1 is fused and bonded to the chip substrate 2 along the periphery of the chip substrate 2.

In an example, when materials of the heat sink plate 41, the peripheral substrate 1, and the chip substrate 2 are all plastic, to achieve air-tightness between the peripheral substrate 1 and the chip substrate 2, and to achieve air-tightness between the peripheral substrate 1 and the heat sink plate 41, fused bonding may be used between the heat sink plate 41 and the peripheral substrate 1, and between one end of the peripheral substrate 1 and the chip substrate 2.

In another example, when materials of the heat sink plate 41, the peripheral substrate 1, and the chip substrate 2 are all pure iron, welding may be used between the heat sink plate 41 and the peripheral substrate 1, and between one end of the peripheral substrate 1 and the chip substrate 2. In this way, sealing between the heat sink plate 41 and the peripheral substrate 1 and sealing between the one end of the peripheral substrate 1 and the chip substrate 2 can be ensured, and stability and firmness of the heat dissipation structure can also be improved.

In an example, when welding is used between the heat sink plate 41 and the peripheral substrate 1, and between the one end of the peripheral substrate 1 and the chip substrate 2, the heat sink plate 41 may be welded to the peripheral substrate 1 by using a solder layer, and the one end of the peripheral substrate 1 may be welded to the chip substrate 2 by using the solder layer. For example, solder in the solder layer may be tin. Because tin has a high thermal conductivity coefficient, when tin is used as the solder, the thermal conductivity of the thermally conductive material 3 is not affected. In addition, by setting a solder layer thickness of the solder tin to be within a reference range, the heat dissipation speed of the chip can be further improved, and the chip is prevented from being damaged by a large amount of heat. For example, the thickness of the solder layer may be set between 0.1 millimeters and 0.15 millimeters, for example, may be 0.1 millimeters, 0.11 millimeters, 0.12 millimeters, 0.13 millimeters, 0.14 millimeters, or 0.15 millimeters. Further, to prevent the thermally conductive material 3 from dissolving the solder tin when the chip is working, soldering may be performed from the outside, and the solder may be prevented from contacting the thermally conductive material 3 as much as possible.

In an example embodiment, the thermally conductive material 3 is liquid metal.

The thermally conductive material 3 provided in this embodiment of this application is liquid metal, that is, the thermally conductive material is in a liquid state at least when the chip works. It may be understood that some metals are in the liquid state at a normal temperature, for example, 25°C, and are in the liquid state even when the temperature is greater than 0°C. When the chip is working, the metal is in the liquid state. Alternatively, when the chip does not work, but in a normal temperature environment, the metal is also in the liquid state.

The liquid metal is selected, so that a quantity of heat transfer phases is reduced, and heat dissipation efficiency of the chip can be improved. In addition, wear between the thermally conductive material 3 and the silicon die can be further reduced, and production costs of the chip can be reduced.

In an example embodiment, the liquid metal is gallium or a gallium alloy, where the gallium alloy may be any alloy that includes gallium.

It may be understood that the liquid metal may dissipate heat generated by the chip to the heat sink 4. Therefore, selection of the liquid metal is very important. It is required that the metal can be liquefied when the chip is working, that is, the metal is in the liquid state; and the metal needs to have a high thermal conductivity coefficient, that is, have a low thermal resistance, and can be highly combined with the silicon die 6 to efficiently dissipate heat. Metal mercury has good thermal conductivity and low thermal resistance, but it is toxic. Therefore, it is not recommended to use mercury as the thermally conductive material 3.

On the contrary, the gallium and the gallium alloy are in a liquid state when the chip works, and the gallium and the gallium alloy have a very low melting point and a very high boiling point. Therefore, both the gallium and the gallium alloy can be adhered to the silicon die 6 very well, and an adhesion degree is high, so that thermal resistance at an interface between the silicon die 6 and the gallium or the gallium alloy can be reduced. In addition, because the gallium and the gallium alloy have high adhesion degree with the silicon die 6, when the gallium or the gallium alloy is filled in the accommodation space, the silicon die 6 is not damaged, and heat dissipation efficiency of the chip is also improved.

In an example, the liquid metal may be the gallium alone, or may be the gallium alloy, or may be a mixture of the gallium and the gallium alloy. When the liquid metal is the mixture of the gallium and the gallium alloy, a mixing proportion may be 1:1 to 2. For example, the mixing proportion may be 1:1, 1:2, or the like. The mixing proportion of the mixture of the gallium and the gallium alloy is not limited in this embodiment of this application.

It should be noted that, in the heat dissipation structure provided in the related technology, because air exists between the heat sink 4 and the chip cover, and a thermal conductivity coefficient of the air is very low, a heat dissipation rate is slow. Therefore, a second layer of thermally conductive material needs to be filled between the heat sink 4 and the chip cover, to improve heat dissipation of the chip, but a heat transfer phase is also added, and thermal resistance is increased.

However, in this embodiment of this application, the accommodation space formed by the heat sink plate 41, the chip substrate 2, and the peripheral substrate 1 is filled with gallium or gallium alloy, so that the chip cover is prevented from being disposed on the silicon die 6, and heat transfer phases are reduced; in addition, heat dissipation efficiency is prevented from being affected due to the low thermal conductivity of air between the chip cover and the heat sink 4.

In addition, in the heat dissipation structure provided in the related technology, a first layer of thermally conductive material needs to be added between the silicon die 6 and the chip cover, to improve heat dissipation of the chip. However, because of a low adhesion degree between the first layer of thermally conductive material provided in the related technology and the silicon die 6, friction is generated between the first layer of thermally conductive material and the silicon die 6, and the silicon die 6 is damaged. Consequently, preparation costs of the heat dissipation structure are increased, and heat dissipation efficiency is low.

However, according to the heat dissipation structure provided in this embodiment of this application, the accommodation space is filled with the gallium or the gallium alloy. This not only reduces damage to the silicon die 6, but also increases a heat dissipation speed, so that the preparation costs of the heat dissipation structure are further reduced.

In an example embodiment, the gallium alloy is selected from at least one of a gallium-aluminum alloy, a gallium-bismuth alloy, a gallium-tin alloy, a gallium-indium alloy, a gallium-copper alloy, a gallium-gold alloy, and a gallium-silver alloy.

Because the thermally conductive material 3 selected in this embodiment of this application is liquid metal, that is, when the chip works, the thermally conductive material 3 needs to be in a liquid state, the gallium alloy may be in the liquid state at a low temperature, for example, 0°C, and remains in the liquid state when the chip works. In addition, the gallium alloy has good thermal conductivity, low thermal resistance, and a high adhesion degree with the silicon die 6, so that thermal resistance of heat dissipation between the gallium alloy and the silicon die 6 can be significantly reduced.

In an example, the gallium alloy may be any one of a gallium aluminum alloy, a gallium bismuth alloy, a gallium tin alloy, a gallium indium alloy, a gallium copper alloy, a gallium gold alloy, and a gallium silver alloy, or may be a mixture of any two of the foregoing, for example, a mixture of a gallium aluminum alloy and a gallium bismuth alloy, a mixture of a gallium aluminum alloy and a gallium tin alloy, a mixture of a gallium aluminum alloy and a gallium indium alloy, a mixture of a gallium bismuth alloy and a gallium tin alloy, a mixture of a gallium tin alloy and a gallium indium alloy, or a mixture of a gallium bismuth alloy and a gallium indium alloy. When the gallium alloy is the mixture of any two of the foregoing, a mixing proportion may be 1:1 or 1:2. The mixing proportion of the two is not limited in this embodiment of this application. Alternatively, the gallium alloy may be a mixture of any three of the foregoing, for example, a mixture of a gallium aluminum alloy, a gallium bismuth alloy, and a gallium tin alloy, a mixture of a gallium bismuth alloy, a gallium tin alloy, and a gallium indium alloy, or a mixture of a gallium aluminum alloy, a gallium tin alloy, and a gallium indium alloy, and a mixing proportion may be 1:1:1 or 1:2:1. The mixing proportion of the three is not limited in this embodiment of this application. Alternatively, the gallium alloy may be a mixture of any four of the foregoing, for example, a mixture of a gallium aluminum alloy, a gallium bismuth alloy, a gallium tin alloy, and a gallium indium alloy, and a mixing proportion may be 1:1:2:1. The mixing proportion of the four is not limited in this embodiment of this application.

In an example embodiment, materials of the peripheral substrate 1, the chip substrate 2, and the heat sink plate 41 may be pure iron materials or plastic materials.

Metals tend to form alloys, and alloys are formed through a phenomenon of mutual dissolution between different metals. Generally, forming alloys by metals requires a high temperature. However, mutual dissolution between some metals does not need the high temperature. Because a melting point of the gallium is very low, the gallium becomes liquid at less than 30°C, and liquid gallium can form an alloy with another metal, that is, the liquid gallium can dissolve the another metal and corrode the another metal. Therefore, the gallium cannot be contained in a metal container.

However, iron cannot react directly with the gallium, so the liquid gallium and a liquid gallium alloy do not react with a pure iron container at a high temperature. Therefore, the peripheral substrate 1, the chip substrate 2, and the heat sink plate 41 provided in this embodiment of this application may be made of a pure iron material, or may be made of another metal material. However, a problem that an alloy is generated between the selected metal material and the liquid metal needs to be considered.

In addition, the gallium and the gallium alloy do not corrode plastic. Therefore, the peripheral substrate 1 and the chip substrate 2 may alternatively be made of a plastic material.

In an example embodiment, the heat sink plate 41 may also be made of a plastic material. In a working process of the chip, the thermally conductive material 3 is in the liquid state, and the heat sink plate 41 may also contact the thermally conductive material 3. Therefore, the material of the heat sink plate 41 may also be a plastic material.

In an example embodiment, the plastic is polyimide, polyetheretherketone, polyamide-imide, polybenzimidazole, polyetherimide, polyphenylene sulfide, polysulfone, polytetrafluoroethylene, or polyvinylidene fluoride.

It should be noted that the plastics provided in this embodiment of this application are all high-temperature-resistant thermosetting plastics. The high-temperature-resistant plastics are used, so that when the chip works, the peripheral substrate 1 not only can resist dissolution and corrosion of the gallium or the gallium alloy, but also cannot be deformed or dissolved at the high temperature.

For example, a long-term working temperature of the polybenzimidazole may reach 310°C, and a short-term working temperature thereof may reach 500°C. Therefore, the polybenzimidazole may be selected to meet a high-power-consumption working status of the chip. A long-term working temperature of the polyimide may reach 290°C, and a short-term working temperature thereof may reach 480°C. The polyimide may also work in an environment of -240°C. The polyamide-imide is also a thermosetting plastic, a long-term operating temperature thereof may reach 250°C, and the polyamide-imide also have excellent wear and impact resistance. A long-term working temperature of the polyetheretherketone may reach 160°C, and a short-term working temperature thereof may reach 260°C. The polyetheretherketone has good high-temperature resistance. A long-term working temperature of the polyetherimide may reach 170°C, and a short-term working temperature thereof may reach 200°C. A long-term working temperature of the polyphenylene sulfide may reach 220°C, and a short-term working temperature thereof may reach 260°C. A long-term working temperature of the polyvinylidene fluoride may reach 150°C, and a short-term working temperature thereof may reach 160°C. The polyvinylidene fluoride also has excellent corrosion resistance, and has high mechanical strength and rigidity. A long-term working temperature of the polytetrafluoroethylene may reach 260°C, and a short-term working temperature thereof is 280°C. The polytetrafluoroethylene has excellent corrosion resistance, and also has an extremely low friction factor. A long-term working temperature of the polysulfone is 150°C, and a short-term working temperature thereof may reach 180°C.

It can be learned that all the foregoing plastics provided in this embodiment of this application are thermosetting plastics, can work at the high temperature, and can also adapt to work in a low-temperature environment, so that a working requirement of the chip at high power consumption can be met.

It should be noted that, although the gallium or the gallium alloy may mutually dissolve with another metal, because dissolution between the gallium or the gallium alloy and some metals is trivial, it takes a very long time for the gallium or the gallium alloy to completely dissolve with the another metal. That is, in a normal working period of the chip, dissolution between the gallium or the gallium alloy and the another metal does not affect normal working of the chip. Therefore, the peripheral substrate 1, the chip substrate 2, and the heat sink plate 41 provided in this embodiment of this application may also be made of metal. In an example, the peripheral substrate 1, the chip substrate 2, and the heat sink plate 41 may be made of copper or steel.

In an example embodiment, there may be a reference gap between the thermally conductive material 3 and the heat sink 4.

It should be noted that the thermally conductive material 3 provided in this embodiment of this application is a liquid metal, the liquid metal changes from a solid state to a liquid state when the chip works, and density of the liquid metal in the liquid state is greater than density of the liquid metal in the solid state. Therefore, when the chip works, the thermally conductive material 3 changes from the solid state to the liquid state, and a volume of the thermally conductive material 3 decreases; when the chip does not work or is in a low-temperature environment, for example, an environment of minus 30°C, the thermally conductive material 3 changes to the solid state, and the volume of the thermally conductive material 3 increases. Therefore, a reference gap is disposed between the thermally conductive material 3 and the heat sink 4, to avoid that when the thermally conductive material 3 changes to the solid state, an overall function of the chip is affected because a volume of the accommodation space decreases.

In an example, when the thermally conductive material 3 is the gallium or the gallium alloy, the gallium or the gallium alloy changes to the liquid state when the chip works. When the chip does not work or is at a low temperature, for example, minus 30°C, the gallium or the gallium alloy changes to the solid state. In this case, space needs to be reserved for the gallium or the gallium alloy to become larger in volume. Although the gallium or the gallium alloy is usually in the liquid state at 30°C or above, the gallium or the gallium alloy is also in the liquid state at 0°C, that is, the gallium or the gallium alloy may also be in the liquid state when the chip does not work. However, to avoid that the gallium or the gallium alloy changes to the solid state when a working environment of the chip is at an extremely low temperature, for example, at -20°C or -30°C, a reference gap is disposed between the thermally conductive material 3 and the heat sink 4 in this embodiment of this application, to prevent the foregoing situation.

However, when the gallium or the gallium alloy changes from the liquid state to the solid state, a volume change is very small. Therefore, the reference gap between the thermally conductive material 3 and the heat sink 4 may not be excessively large. If the gap is excessively large, air may be retained in the gap, which affects heat dissipation. However, the gap cannot be excessively small. If the gap is excessively small, when the gallium or the gallium alloy changes from the liquid state to the solid state, the peripheral substrate 1 is squeezed, or the silicon die 6 is squeezed, so that the silicon die 6 is damaged. In an example, the reference gap may be 0.1 millimeters to 0.15 millimeters, for example, may be 0.1 millimeters, 0.11 millimeters, 0.12 millimeters, 0.13 millimeters, 0.14 millimeters, or 0.15 millimeters.

In an example embodiment, a surface that is of silicon die 6 and that is in contact with the thermally conductive material 3 is a smooth surface.

By setting a surface on which the silicon die 6 contacts the thermally conductive material 3 to be a smooth surface, abrasion or damage caused by the thermally conductive material 3 to the silicon die 6 can be avoided, and a contact area between the silicon die 6 and the thermally conductive material 3 is increased, so that a heat dissipation speed between the silicon die 6 and the thermally conductive material 3 increased.

In an example, when the thermally conductive material 3 is the gallium or the gallium alloy, the surface on which the silicon die 6 contacts the thermally conductive material 3 is set to be a smooth surface, so that the contact area between the gallium or the gallium alloy and the silicon die 6 can be further increased, and an adhesion degree between the silicon die 6 and the gallium or the gallium alloy is improved, so that heat dissipation is improved and damage to the chip by excess heat is avoided.

For example, the surface on which the silicon die 6 contacts the thermally conductive material 3 may also be set to be an arc surface. In this application, a shape of the surface on which the silicon die 6 contacts the thermally conductive material 3 is not limited thereto, provided that the contact area can be increased and the heat dissipation efficiency can be improved.

It should be noted that the heat dissipation structure provided in this embodiment of this application not only may be applied to a chip with high power consumption greater than 250 W, but also may be applied to a chip with relatively low power consumption, for example, a chip with power consumption less than 250 W, or may be applied to work of a chip with low power consumption in a high-temperature environment, for example, a high-temperature working environment such as automobile electronics or a wireless power amplifier.

According to another aspect, an embodiment of this application further provides a chip structure, where the chip structure includes a chip body and any foregoing heat dissipation structure disposed on the chip body. For example, the chip body includes a silicon die 6.

The heat dissipation structure provided in the foregoing embodiment is used as the heat dissipation structure. For a structure and a principle of the heat dissipation structure, refer to the foregoing embodiments. Details are not described herein again.

In this embodiment, the heat dissipation structure provided in the foregoing embodiment is disposed on the silicon die 6 of the chip body. Because heat generated by a chip may be dissipated only by using two heat transfer phases: the silicon die 6 and the thermally conductive material 3, a quantity of heat transfer phases is reduced, so that thermal resistance between the heat transfer phases is reduced. Even when power consumption of the chip increases, the heat generated by the chip may be transferred by using the silicon die 6 and the thermally conductive material 3, so that heat dissipation efficiency is improved.

According to still another aspect, an embodiment of this application further provides a circuit board 5. As shown in FIG. 5, at least one foregoing heat dissipation structure is disposed on the circuit board 5.

At least one chip structure in the foregoing embodiments is disposed on the circuit board 5 in this embodiment of this application.

For example, refer to FIG. 5. At least one chip structure in the foregoing embodiments is disposed on the circuit board 5, and the chip structure is fixedly connected to the circuit board 5. For example, the chip structure may be welded to the circuit board 5, or fastened to the circuit board 5 by using a bolt. A location of the chip structure and a quantity of chip structures on the circuit board 5 are not limited. For example, at least one chip structure may be disposed on an upper surface of the circuit board 5; or at least one chip structure may be disposed on an upper surface of the circuit board 5, and at least one chip structure is disposed on a lower surface of the circuit board 5.

For a structure and a principle of the chip structure, refer to the foregoing embodiments. Details are not described herein again.

According to the circuit board 5 provided in this embodiment of this application, at least one chip structure in the foregoing embodiment is disposed on the circuit board 5. Because heat generated by a chip is dissipated only by using two heat transfer phases: the silicon die 6 and the thermally conductive material 3, a quantity of heat transfer phases is reduced, so that thermal resistance between the heat transfer phases is reduced. Even when power consumption of the chip increases, the heat generated by the chip may be transferred by using the silicon die 6 and the thermally conductive material 3, so that heat dissipation efficiency is improved.

According to yet another aspect, an embodiment of this application further provides an electronic device, and at least one foregoing circuit board 5 is disposed in the electronic device.

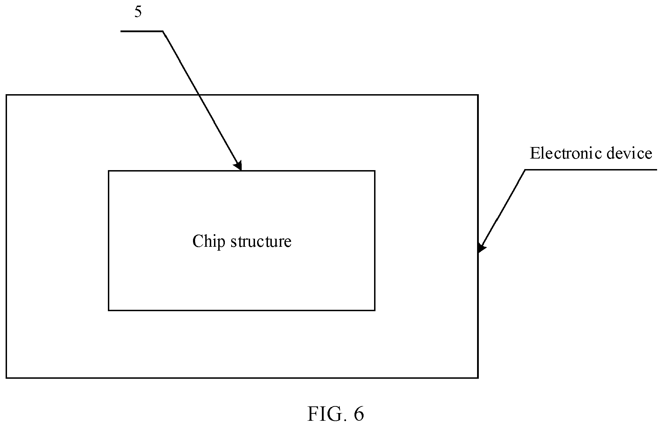

FIG. 6 is a schematic diagram of a structure of an electronic device according to an embodiment of this application. As shown in FIG. 6, at least one circuit board 5 provided in the foregoing embodiments is disposed in the electronic device provided in this embodiment of this application. For a structure and a principle of the circuit board 5, refer to the foregoing embodiments. Details are not described herein again.

In an example, the circuit boards 5 in the electronic device are connected in parallel.

In an example, one or more circuit boards 5 are disposed in the electronic device, and the circuit board 5 provided in the foregoing embodiments is used as the circuit board 5. For a structure and a function of the circuit board 5, refer to descriptions of the foregoing embodiments. Details are not described herein again.

In this embodiment, a plurality of circuit boards 5 may be connected in parallel, and then the circuit boards 5 connected in parallel are disposed in the electronic device. In an implementation, the electronic device may be a server. A fixed connection manner or a sliding connection manner may be selected as a connection manner between the circuit board 5 and the electronic device. For example, one or more sliding slots may be disposed on a chassis of the electronic device, and then the circuit board 5 is disposed in the sliding slot, so that the circuit board 5 can slide on the sliding slot. When a plurality of circuit boards 5 are disposed in the electronic device, structures of circuit boards 5 in the plurality of circuit boards 5 may be the same or different. At least one chip structure in the foregoing embodiments is disposed on each circuit board 5. For a structure and a principle of the chip structure, refer to the foregoing embodiments. Details are not described herein again.

According to the electronic device provided in this embodiment of this application, the one or more circuit boards 5 provided in the foregoing embodiments are disposed in the electronic device, so that the at least one chip structure in the foregoing embodiments is disposed on each circuit board 5, and the heat dissipation structure provided in the foregoing embodiments is disposed on a silicon die 6 of the chip structure. Because heat generated by a chip is dissipated only by using two heat transfer phases: the silicon die 6 and the thermally conductive material 3, a quantity of heat transfer phases is reduced, so that thermal resistance between the heat transfer phases is reduced. Even if power consumption of the chip increases, the heat generated by the chip may be transferred by using the silicon die 6 and the thermally conductive material 3, so that heat dissipation efficiency is improved.

An embodiment of this application provides a production method of a heat dissipation structure, where the heat dissipation structure includes a peripheral substrate 1, a chip substrate 2, a thermally conductive material 3, and a heat sink 4. For detailed descriptions of the heat dissipation structure, refer to the content of the foregoing embodiment of this application. Details are not described herein again. For example, the production method of a heat dissipation structure includes the following steps:
Step 11: Connect one end of the peripheral substrate 1 to the chip substrate 2 along a periphery of the chip substrate 2, where a silicon die 6 is placed on the chip substrate 2.

For example, the one end of the peripheral substrate 1 is connected to the chip substrate 2 along the periphery of the chip substrate 2 through sealing.

It should be noted that before the one end of the peripheral substrate 1 is connected to the chip substrate 2 along the periphery of the chip substrate 2, the silicon die 6 may be first placed on the chip substrate 2. In addition, the silicon die 6 may be placed on the chip substrate 2 after the one end of the peripheral substrate 1 is connected to the chip substrate 2 along the periphery of the chip substrate 2. A placement sequence of the silicon die 6 is not limited in this embodiment of this application.

Step 12: Fill the thermally conductive material 3 in accommodation space formed between the chip substrate 2 and the peripheral substrate 1.

Step 13: Connect the heat sink 4 to the other end of the peripheral substrate 1 to close the accommodation space.

In an example embodiment, the heat sink 4 includes a heat sink plate 41 and at least one heat sink fin 42. Therefore, the connecting the heat sink 4 to the other end of the peripheral substrate 1 includes: connecting each heat sink fin 42 to one side of the heat sink plate 41, and connecting the other side of the heat sink plate 41 to the other end of the peripheral substrate 1. For example, the other side of the heat sink plate 41 is connected to the other end of the peripheral substrate 1 through sealing.

In an example embodiment, the heat sink 4 further includes a connection part 43. In this case, the method further includes: connecting an upper surface of the connection part 43 to each heat sink fin 42, and connecting a lower surface of the connection part 43 to the heat sink plate 41. There is a reference angle between the connection part 43 and the heat sink plate 41.

With the heat dissipation structure produced by using the method, because heat generated by a chip may be dissipated only by using two heat transfer phases: the silicon die and the thermally conductive material, a quantity of heat transfer phases is reduced, so that thermal resistance between the heat transfer phases is reduced. Even if power consumption of the chip increases, the heat generated by the chip may be transferred by using the silicon die and the thermally conductive material, so that heat dissipation efficiency is improved.

A sequence of steps in the foregoing production method may be changed without affecting implementation of the solutions.

All the foregoing optional technical solutions may be randomly combined to form optional embodiments of this application, and details are not described herein.

The foregoing descriptions are merely specific embodiments of this application, but are not intended to limit this application. Any modification, equivalent replacement, or improvement made without departing from the spirit and principle of this application should fall within the protection scope of this application.

## Claims

1. A heat dissipation structure, wherein the heat dissipation structure comprises a peripheral substrate (1), a chip substrate (2), a thermally conductive material (3), and a heat sink (4), wherein
one end of the peripheral substrate (1) is connected to the chip substrate (2) along a periphery of the chip substrate (2), and the heat sink (4) is connected to the other end of the peripheral substrate (1); and
there is accommodation space among the peripheral substrate (1), the heat sink (4), and the chip substrate (2), the thermally conductive material (3) is filled in the accommodation space, and the chip substrate (2) is configured to place a silicon die (6).

2. The heat dissipation structure according to claim 1, wherein the heat sink (4) comprises a heat sink plate (41) and at least one heat sink fin (42);
each heat sink fin (42) is connected to one side of the heat sink plate (41); and
the other side of the heat sink plate (41) is connected to the other end of the peripheral substrate (1), and there is the accommodation space among the heat sink plate (41), the peripheral substrate (1), and the chip substrate (2).

3. The heat dissipation structure according to claim 2, wherein the heat sink (4) further comprises a connection part (43), an upper surface of the connection part (43) is connected to each heat sink fin (42), and a lower surface of the connection part (43) is connected to the heat sink plate (41); and
there is a reference angle between the connection part (43) and the heat sink plate (41).

4. The heat dissipation structure according to claim 2 or 3, wherein the other side of the heat sink plate (41) is connected to the other end of the peripheral substrate (1) through sealing.

5. The heat dissipation structure according to any one of claims 1 to 4, wherein the one end of the peripheral substrate (1) is connected to the chip substrate (2) along the periphery of the chip substrate (2) through sealing.

6. The heat dissipation structure according to any one of claims 1 to 5, wherein the thermally conductive material (3) is liquid metal.

7. The heat dissipation structure according to claim 6, wherein the liquid metal is gallium or a gallium alloy.

8. The heat dissipation structure according to claim 7, wherein the gallium alloy is selected from at least one of a gallium-aluminum alloy, a gallium-bismuth alloy, a gallium-tin alloy, a gallium-indium alloy, a gallium-copper alloy, a gallium-gold alloy, and a gallium-silver alloy.

9. The heat dissipation structure according to any one of claims 1 to 8, wherein a surface that is of silicon die (6) and that is in contact with the thermally conductive material (3) is a smooth surface.

10. A chip structure, wherein the chip structure comprises a chip body and a heat dissipation structure disposed on the chip body, and the heat dissipation structure is the heat dissipation structure according to any one of claims 1 to 9.

11. An electronic device, wherein the electronic device comprises a circuit board, and the circuit board has the chip structure according to claim 10.

12. A production method of a heat dissipation structure, wherein the heat dissipation structure comprises a peripheral substrate (1), a chip substrate (2), a thermally conductive material (3), and a heat sink (4), and the method comprises:
connecting one end of the peripheral substrate (1) to the chip substrate (2) along a periphery of the chip substrate (2), wherein a silicon die (6) is placed on the chip substrate (2);
filling the thermally conductive material (3) in accommodation space formed between the chip substrate (2) and the peripheral substrate (1); and
connecting the heat sink (4) to the other end of the peripheral substrate (1) to close the accommodation space.

13. The method according to claim 12, wherein the heat sink (4) comprises a heat sink plate (41) and at least one heat sink fin (42); and
the connecting the heat sink (4) to the other end of the peripheral substrate (1) comprises:
connecting each heat sink fin (42) to one side of the heat sink plate (41), and connecting the other side of the heat sink plate (41) to the other end of the peripheral substrate (1).

14. The method according to claim 13, wherein the heat sink (4) further comprises a connection part (43); and
the method further comprises:
connecting an upper surface of the connection part (43) to each heat sink fin (42), and connecting a lower surface of the connection part (43) to the heat sink plate (41), wherein there is a reference angle between the connection part (43) and the heat sink plate (41).
